(19) Europäisches Patentamt
European Patent Office
Office européen des brevets

(11) **EP 1 195 000 B1**

(12) **EUROPÄISCHE PATENTSCHRIFT**

(45) Veröffentlichungstag und Bekanntmachung des Hinweises auf die Patenterteilung:
**15.01.2003 Patentblatt 2003/03**

(21) Anmeldenummer: **00938530.3**

(22) Anmeldetag: **26.04.2000**

(51) Int Cl.⁷: **H03B 5/12**

(86) Internationale Anmeldenummer:
**PCT/DE00/01385**

(87) Internationale Veröffentlichungsnummer:
**WO 00/076057 (14.12.2000 Gazette 2000/50)**

(54) **SPANNUNGSGESTEUERTER OSZILLATOR MIT LC-SCHWINGKREIS**

VOLTAGE-CONTROLLED OSCILLATOR WITH LC RESONANT CIRCUIT

OSCILLATEUR COMMANDE EN TENSION AVEC CIRCUIT OSCILLATEUR LC

(84) Benannte Vertragsstaaten:
**AT BE CH CY DE DK ES FI FR GB GR IE IT LI LU MC NL PT SE**

(30) Priorität: **05.06.1999 DE 19925742**
**26.04.2000 DE 10021273**

(43) Veröffentlichungstag der Anmeldung:
**10.04.2002 Patentblatt 2002/15**

(73) Patentinhaber:
• **IHP GmbH-Innovations for High Performance Microelectronics/Institut für innovative Mikroelektronik**
**15236 Frankfurt an der Oder (DE)**
Benannte Vertragsstaaten:
**DE**
• **Herzel, Frank, Dr.**
**15230 Frankfurt (Oder) (DE)**
Benannte Vertragsstaaten:
**AT BE CH LI CY DK ES FI FR GB GR IE IT LU MC NL PT SE**

(72) Erfinder:
• **HERZEL, Frank, Dr.**
**D-15230 Frankfurt (Oder) (DE)**
• **WEGER, Peter**
**D-15232 Frankfurt (oder) (DE)**

(74) Vertreter: **Heitsch, Wolfgang**
**Göhlsdorfer Strasse 25g**
**14778 Jeserig (DE)**

(56) Entgegenhaltungen:
**EP-A- 0 911 960          US-A- 5 808 531**

**Beschreibung**

Die Erfindung betrifft einen spannungsgesteuerten Oszillator mit LC-Schwingkreis, insbesondere zur Realisierung integrierter spannungsgesteuerter Oszillatoren für den unteren GHz-Bereich.

In integrierten Schaltungen werden spannungsgesteuerte Oszillatoren meist in Form von Ringoszillatoren oder LC-Oszillatoren verwendet. Ringoszillatoren zeichnen sich durch eine hohe Frequenzdurchstimmbarkeit aus. Dieser Vorteil wird jedoch durch ein starkes Phasenrauschen und ein starkes Phasenjitter beeinträchtigt. Bei LC-Oszillatoren wird die Frequenzdurchstimmbarkeit vorwiegend mit Hilfe variabler Kapazitäten, beispielsweise Kapazitätsdioden, herbeigeführt. Diese Oszillatoren weisen zwar ein geringeres Phasenrauschen und ein geringeres Phasenjitter auf, jedoch ist die Frequenzdurchstimmbarkeit meist erheblich eingeschränkt.

In der JP 093 215 38 A wird eine spannungsgesteuerte LC-Oszillatorschaltung beschrieben, bei der mit Hilfe eines Schalttransistors ein Teil der Induktivität für bestimmte Zeitabschnitte kurzgeschlossen wird, wodurch sich die induktive Komponente zeitweise derart verringert, daß ein wechselweiser Betrieb des Oszillators in zwei Frequenzbändern möglich ist. Aus EP-A-0 911 960 ist ebenfalls eine spannungsgesteuerte LC-Oszillator schaltung bekannt, bei der eine weitere Induktivität parallel schaltbar ist.

Abgesehen von dem Schaltvorgang, der wesentlich langsamer als die Periodendauer in dem angestrebten Frequenzbereich ist, gestattet eine derartige Lösung nicht das kontinuierliche

Durchstimmen der Frequenz in einem weiten Frequenzbereich.

Ein ähnliches Prinzip wird auch in: A. Kral et al "RF-CMOS-Oscillators with Switched Tuning," Custom Integrated Circuits Conference (CICC'98), pp. 555 - 558 beschrieben. Bei einem vollintegrierten CMOS-Oszillator für einen Frequenzbereich zwischen 1 und 2 GHz wird ein Durchstimmbereich von etwa 26% durch das Schalten zwischen mehreren diskreten Induktivitätswerten erzielt.

Neben dem Einsatz von Schaltelementen, die das Phasenrauschen und das Phasenjitter negativ beeinflussen, tritt bei dieser Lösung der Nachteil zu Tage, daß trotz einer hohen Komplexität der Schaltung nur ein relativ begrenzter Durchstimmbereich der Frequenz erzielt werden konnte. Zudem kann durch das Schalten diskreter Induktivitätswerte nur ein quasikontinuierliches Durchstimmen der Frequenz erzeugt werden, welches durch kapazitives Durchstimmen ergänzt werden muss.

In integrierten Radiosystemen muss der Oszillator einen relativ großen Durchstimmbereich besitzen, um Technologie- und Temperaturschwankungen auszugleichen sowie das Empfangs- bzw. Sendeband zu überdecken.

Bei immer kleiner werdenden Betriebsspannungen in modernen Technologien wird der verfügbare Spannungsbereich für die Kontrollspannung des spannungsgesteuerten Oszillators (VCO) immer kleiner. Damit wächst die notwendige Empfindlichkeit der Schwingfrequenz des Oszillators gegenüber Kontrollspannungsänderungen. Dies hat zur Folge, dass bei der Integration des VCOs in einer phase-locked loop (PLL) das Rauschen der Kontrollspannung ein starkes Phasenrauschen bewirkt. Dieses Problem verschärft sich bei Skalierung der Technologie, welche mit der Verringerung der Versorgungsspannung einhergeht.

Es ist somit Aufgabe der Erfindung, einen spannungsgesteuerten Oszillator mit LC-Schwingkreis vorzuschlagen, mit dem die Nachteile des Standes der Technik beseitigt werden und mit dem insbesondere bei geringem Phasenrauschen und Phasenjitter eine kontinuierliche Frequenzdurchstimmbarkeit in einem weiten Bereich erzielbar ist.

Erfindungsgemäß wird die Aufgabe mit einem spannungsgesteuerten Oszillator gemäß Anspruch 1 gelöst. Vorteilhafterweise ist mehreren Induktivitäten über je eine steuerbare Schaltvorrichtung eine weitere Induktivität periodisch parallel oder in Reihe schaltbar. Die steuerbaren Schaltvorrichtungen weisen periodisch einen leitenden und anschließend einen nichtleitenden Zustand auf. Sie sind durch eine veränderbare Steuerspannung steuerbar. Dabei ist das Verhältnis der Dauer des leitenden

Zustandes und der Dauer des nichtleitenden Zustandes der Schaltvorrichtungen innerhalb einer Schwingungsperiode des Oszillators in Abhängigkeit von dem Wert der Steuerspannung veränderbar. Entsprechend dem Verhältnis der Dauer des leitenden Zustandes und der Dauer des nichtleitenden Zustandes der Schaltvorrichtungen innerhalb einer Schwingungsperiode des Oszillators ist die zeitgemittelte, wirksame Induktivität in Abhängigkeit von dem Wert der Steuerspannung veränderbar. Die steuerbaren Schaltvorrichtungen sind vorteilhafterweise Schalttransistoren und insbesondere MOSFET, deren Gate-Anschlüsse an den Eingang der Steuerspannung und deren Source-Anschlüsse an die Oszillatorfrequenz führende Teile der Schaltungsanordnung geschaltet sind. Vorteilhafterweise ist der Oszillator in einer CMOS- oder bipolaren Technologie ausgeführt und ist bevorzugt in Frequenzsynthesizern für Breitbandsysteme sowie für Multibandanwendungen und für die Takterzeugung und Taktrückgewinnung in Hochgeschwindigkeitsschaltungen, wie beispielsweise Mikroprozessoren und Speichern, einsetzbar.

Die Lehre der Erfindung besteht in dem Ersatz der Spulen in einem Schwingkreis durch Paare parallel oder in Reihe geschalteter Spulen, von denen jeweils eine der Spulen mit einem periodisch geöffneten und geschlossenen Schalter verbunden ist. Damit ist jeweils nur eine Spule beziehungsweise die Parallel- oder Reihenschaltung beider Spulen wirksam. Die Zeitspanne, während der der Schalter innerhalb einer Schwingungsperiode geschlossen ist, wird durch eine Steuerspannung kontrolliert. Die zeitgemittelte wirksame Induktivität lässt sich damit in einem weiten Bereich ändern. Das hat die angestrebte kontinuierliche Durchstimmbarkeit der Frequenz zur Folge.

Die Merkmale der Erfindung werden in den Ansprüchen definiert Ausführungsbeispiele der Erfindung werden im folgenden näher erläutert. In den zugehörigen Zeichnungen zeigen:

Fig. 1 - einen erfindungsgemäßen spannungsgesteuerten Oszillator,

Fig. 2 - ein Diagramm der Oszillatorfrequenz als Funktion der Steuerspannung,

Fig. 3 - ein weiteres Ausführungsbeispiel des erfindungsgemäßen Oszillators,

Fig. 4 - einen erfindungsgemäßen spannungsgesteuerten Oszillator,

Fig. 5 - ein weiteres Ausführungsbeispiel des erfindungsgemäßen Oszillators,

Fig. 6 - eine Kombinationsschaltung eines VCO mit einer PLL und

Fig. 7 - eine Kombinationsschaltung eines VCO mit zwei PLLs.

Beispiel 1:

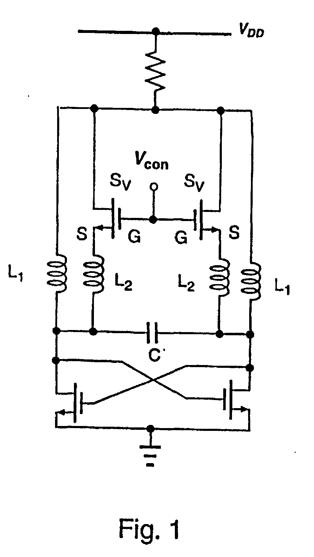

**Fig. 1** zeigt einen erfindungsgemäßen LC-Oszillator mit zwei zusammenwirkenden Halbleiterschaltern und einer Kapazität **C**. Die Induktivitäten $L_1$ sind in zwei Zweigen angeordnet. Den beiden Induktivitäten $L_1$ ist jeweils eine weitere Induktivität $L_2$ zugeordnet, die durch je eine Schaltvorrichtung $S_v$ zu den ersten Induktivitäten $L_1$ parallel schaltbar sind. Die Gate-Anschlüsse **G** der als MOSFET ausgeführten Schaltvorrichtungen $S_v$ sind an einen Steuereingang $V_{con}$ für eine Steuerspannung $U_{con}$ geschaltet, während die Source-Anschlüsse **S** mit dem die Oszillatorfrequenz führenden Ausgang des Oszillators verbunden sind.

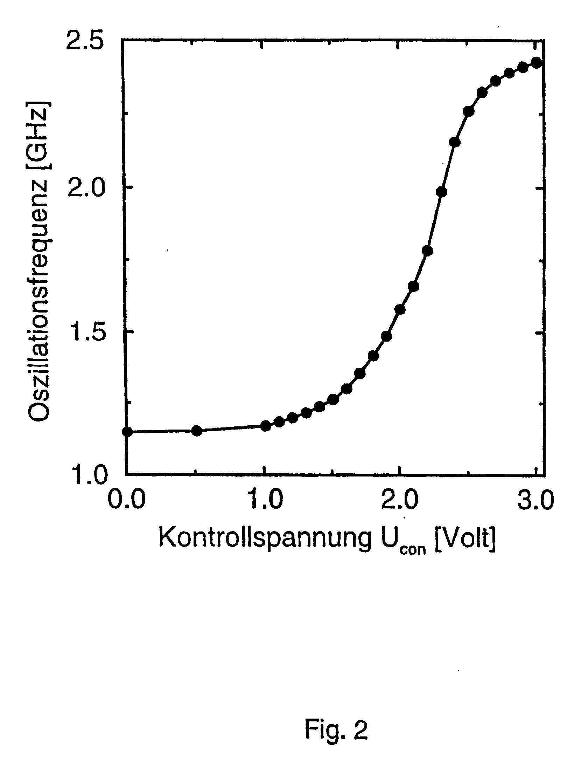

Figur 2 zeigt ein Diagramm der Oszillatorfrequenz in GHz als eine Funktion der Steuerspannung $U_{con}$.

Die Funktion des erfindungsgemäßen Oszillators ist folgende: Die beiden Schaltvorrichtungen $S_v$, in diesem Ausführungsbeispiel zwei MOSFET, sind bei einer niedrigen Steuerspannung $U_{con}$ während des größten Teils einer Schwingungsperiode des Oszillators geöffnet. Dieser Zustand tritt ein, so lange die Gate-Source-Spannung den Schaltpunkt der Schaltvorrichtungen $S_v$ nicht übersteigt. Während der Dauer des nichtleitenden Zustandes der Schaltvorrichtungen $S_v$ sind nur die ersten Induktivitäten $L_1$ wirksam. Für einen geringen Teil der Schwingungsperiode übersteigt die Gate-Source-Spannung den Schaltpunkt der Schaltvorrichtungen $S_v$. Für die Dauer des nunmehr leitenden Zustandes der Schaltvorrichtungen $S_v$ sind die weiteren Induktivitäten $L_2$ zu den ersten Induktivitäten $L_1$ parallel geschaltet, wodurch sich der Gesamtwert der wirksamen Induktivität in einer Funktion der Zeit verringert. Entsprechend dem Verhältnis der längeren Dauer des nichtleitenden Zustandes der Schaltvorrichtungen $S_v$ zu der kürzeren Dauer ihres leitenden Zustandes ergibt sich eine relativ große zeitgemittelte, wirksame Induktivität. Die daraus resultierende Oszillatorfrequenz ist entsprechend niedrig.

Bei einer erhöhten Steuerspannung $U_{con}$ sind die beiden Schaltvorrichtungen $S_v$ nur während eines geringeren Teils der Schwingungsperiode geöffnet und während ihres größeren Teils geschlossen. Entsprechend dem Verhältnis der kürzeren Dauer des nichtleitenden Zustandes der Schaltvorrichtungen $S_v$ zu der längeren Dauer ihres leitenden Zustandes ergibt sich eine relativ geringe zeitgemittelte, wirksame Induktivität. Die daraus resultierende Oszillatorfrequenz ist entsprechend hoch.

Als ein Spezialfall sei angenommen, dass die Induktivität und Güte der Spulenpaare $L_1$ und $L_2$ identisch seien und die Größenwerte L1 und Q1 besitzen. Für den Fall idealer Schaltvorrichtungen $S_v$ gilt dann für die Induktivität L und die Güte Q der Gesamtanordnung bestehend aus $L_1, L_2$ und dem Schalter:

L = L1, Q = Q1 bei geöffneten Schaltvorrichtungen $S_v$ und

L = L1/2, Q = Q1 bei geschlossenen Schaltvorrichtungen $S_v$.

Das Schließen der Schaltvorrichtungen $S_v$ bewirkt also eine Halbierung der für die Oszillatorfrequenz maßgebenden Induktivität. Die Güte der Spulenpaare $L_1$ und $L_2$ ist gleich der Güte der einzelnen Spule. Beachtet man, dass für die Oszillatorfrequenz näherungsweise gilt:

$$f_0 = 1./\sqrt{L},$$

so findet man für die untere Grenzfrequenz $f_0$, min und für die obere Grenzfrequenz $f_0$, max des Frequenzdurchstimmbereichs den Zusammenhang:

$$f_0, max = \sqrt{2} \cdot fo, min.$$

Für den allgemeinen Fall nicht notwendigerweise gleicher Spulen folgt analog:

$$f_0, max = \sqrt{(1 + L1/L2)} \cdot fo, min.$$

Somit kann der Frequenzdurchstimmbereich durch die Wahl eines größeren Verhältnisses von L1/L2 noch weiter erhöht werden.

Figur 2 zeigt den simulierten Frequenzdurchstimmbereich in der Form eines Diagramms der Oszillatorfrequenz $f_0$ als eine Funktion der Steuerspannung $U_{con}$ für L1/L2=2. In diesem Beispiel beträgt der Frequenzdurchstimmbereich etwa 1,25 GHz, das heißt mehr als eine Oktave.

Der erfindungsgemäße Oszillator ist in vollintegrierter Bauweise sowohl in einer CMOSals auch in einer bipolaren Technologie ausführbar. Er ist in vorteilhafter Weise in Frequenzsynthesizern für Breitbandsysteme sowie für Multibandanwendungen und für die Takterzeugung und Taktrückgewinnung in Hochgeschwindigkeitsschaltungen, wie Mikroprozessoren und Speicher, einsetzbar.

Beispiel 2:

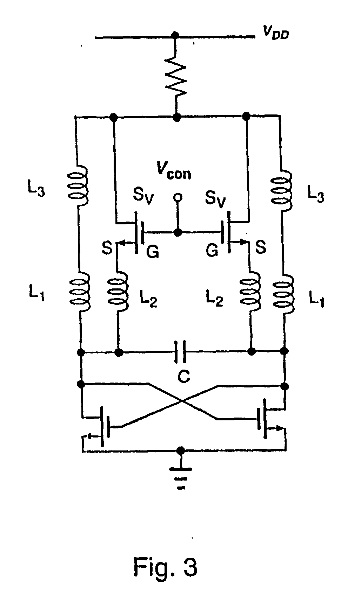

Als ein weiteres Ausführungsbeispiel zeigt Figur 3 eine Schaltungsanordnung des erfindungsgemäßen Oszillators mit jeweils zwei ersten Induktivitäten $L_1$, $L_3$, zu denen jeweils die weitere Induktivität $L_2$ parallel schaltbar ist.

Der Frequenzdurchstimmbereich kann durch die Verwendung von mehr als zwei Induktivitäten $L_1$, $L_2$ erhöht werden, wie in Figur 3 demonstriert.

Beispiel 3:

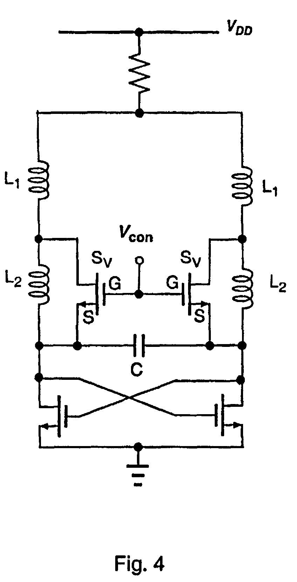

Figur 4 zeigt einen erfindungsgemäßen LC-Oszillator mit zwei zusammenwirkenden Halbleiterschaltern und einer Kapazität **C**. Die Induktivitäten $L_1$ sind in zwei Zweigen angeordnet. Den beiden Induktivitäten $L_1$ ist jeweils eine weitere Induktivität $L_2$ zugeordnet, die durch je eine Schaltvorrichtung $S_v$ zu den ersten Induktivitäten $L_1$ in Reihe schaltbar sind. Die Gate-Anschlüsse **G** der als MOSFET ausgeführten Schaltvorrichtungen $S_v$ sind an einen Steuereingang $V_{con}$ für eine Steuerspannung $U_{con}$ geschaltet, während die Source-Anschlüsse **S** mit dem die Oszillatorfrequenz führenden Ausgang des Oszillators verbunden sind.

Wenn die Schaltvorrichtung $S_v$ geschlossen ist, hat die Gesamtinduktivität einen niedrigeren Wert als bei geöffneter Schaltvorrichtung $S_v$. Die Schaltvorrichtung $S_v$ wird mit der Schwingfrequenz moduliert.

Die Funktion des erfindungsgemäßen Oszillators ist folgende: Die beiden Schaltvorrichtungen $S_v$, in diesem Ausführungsbeispiel zwei MOSFET, sind bei einer niedrigen Steuerspannung $U_{con}$ am Steuereingang $V_{con}$ während des größten Teils einer Schwingungsperiode des Oszillators geöffnet. Dieser Zustand tritt ein, solange die Gate-Source-Spannung den Schaltpunkt der Schaltvorrichtungen $S_v$ nicht übersteigt. Während der Dauer des nichtleitenden Zustandes der Schaltvorrichtungen $S_v$ sind die weiteren Induktivitäten $L_2$ zu den ersten Induktivitäten $L_1$ wirksam, wodurch sich der Gesamtwert der wirksamen Induktivität vergrößert. Für einen geringen Teil der Schwingungsperiode übersteigt die Gate-Source-Spannung den Schaltpunkt der Schaltvorrichtungen $S_v$. Für die Dauer des nunmehr leitenden Zustandes der Schaltvorrichtungen $S_v$ sind nur die ersten Induktivitäten $L_1$ wirksam. Entsprechend dem Verhältnis der längeren Dauer des nichtleitenden Zustandes der Schaltvorrichtungen $S_v$ zu der kürzeren Dauer ihres leitenden Zustandes ergibt sich eine relativ große zeitgemittelte, wirksame Induktivität. Die daraus resultierende Oszillatorfrequenz ist entsprechend niedrig. Bei einer erhöhten Steuerspannung $U_{con}$ sind die beiden Schaltvorrichtungen $S_v$ nur während eines geringeren Teils der Schwingungsperiode geöffnet und während ihres größeren Teils geschlossen. Entsprechend dem Verhältnis der kürzeren Dauer des nichtleitenden Zustandes der Schaltvorrichtungen $S_v$ zu der längeren Dauer ihres leitenden Zustandes ergibt sich eine relativ kleine zeitgemittelte, wirksame Induktivität. Die daraus resultierende Oszillatorfrequenz ist entsprechend höher als bei geringerer Steuerspannung $U_{con}$.

Beispiel 4:

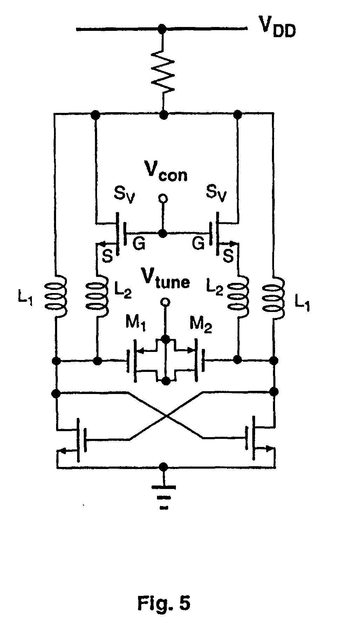

**Fig. 5** zeigt eine Kombination von induktiver und kapazitiver Abstimmung. Neben der induktiven Abstimmung ist zusätzlich eine kapazitive Abstimmung möglich.

Die induktive Abstimmung basiert auf dem in den vorangegangenen Ausführungsbeispielen erläuterten Prinzip. In diesem Ausführungsbeispiel sind die Induktivitäten $L_1$ und $L_2$ parallel geschaltet. Die beiden Schaltvorrichtungen $S_v$ sind bei einer niedrigen Steuerspannung $U_{con}$ am Steuereingang $V_{con}$ während des größten Teils einer Schwingungsperiode des Oszillators geöffnet. Dieser Zustand tritt ein, so lange die Gate-Source-Spannung den Schaltpunkt der Schaltvorrichtungen $S_v$ nicht übersteigt. Während der Dauer des nichtleitenden Zustandes der Schaltvorrichtungen $S_v$ sind nur die ersten Induktivitäten L1 wirksam. Für einen geringen Teil der Schwingungsperiode übersteigt die Gate-Source-Spannung den Schaltpunkt der Schaltvorrichtungen $S_v$. Für die Dauer des nunmehr leitenden Zustandes der Schaltvorrichtungen $S_v$ sind die weiteren Induktivitäten L2 zu den ersten Induktivitäten L1 parallel geschaltet, wodurch sich der Gesamtwert der wirksamen Induktivität in einer Funktion der Zeit verringert. Entsprechend dem Verhältnis der längeren Dauer des nichtleitenden Zustandes der Schaltvorrichtungen $S_v$ zu der kürzeren Dauer ihres leitenden Zustandes ergibt sich eine relativ große zeitgemittelte, wirksame Induktivität. Die daraus resultierende Oszillatorfrequenz ist entsprechend niedrig.

Bei einer erhöhten Steuerspannung $U_{con}$ sind die beiden Schaltvorrichtungen $S_v$ nur während eines geringeren Teils der Schwingungsperiode geöffnet und während ihres größeren Teils geschlossen. Entsprechend dem Verhältnis der kürzeren Dauer des nichtleitenden Zustandes der Schaltvorrichtungen $S_v$ zu der längeren Dauer ihres leitenden Zustandes ergibt sich eine relativ geringe zeitgemittelte, wirksame Induktivität. Die daraus resultierende Oszillatorfrequenz ist entsprechend hoch.

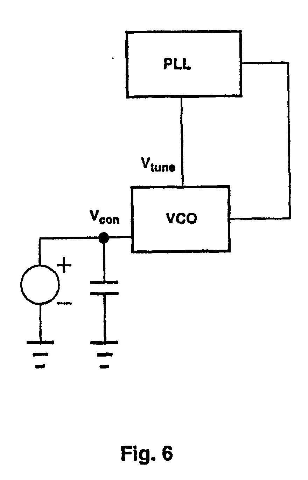

Zur kapazitiven Abstimmung ist eine veränderbare Kapazität im Schwingkreis integriert, welche in diesem Ausführungsbeispiel mittels zweier p-MOSFET **M₁, M₂** als veränderbare Kapazitätsdioden realisiert ist. Der Steuereingang **V_con** ermöglicht eine Abstimmung der Frequenz nach dem in den vorhergehenden Ausführungsbeispielen beschriebenen Prinzip, während eine Abstimmspannung $U_{tune}$ am Abstimmeingang **V_tune** die Schwingfrequenz über die zeitgemittelte Kapazität bestimmt. Man kann nun den Steuereingang **V_con** benutzen, um Technologieschwankungen zu kompensieren, während der Abstimmeingang **V_tune** für die Feinabstimmung mittels einer phase-locked loop **PLL** benutzt wird, wie in Figur 6 gezeigt. Dabei sind der Abstimmeingang **V_tune** des **VCO** mit dem Ausgang der phase-locked loop **PLL** und der Oszillatorausgang des spannungsgesteuerten Oszillators **VCO** mit dem Eingang der phase-locked loop **PLL** verbunden.

Dabei kann ein relativ geringer VCO-Gain $K = df_0/dU_{tune}$ benutzt werden. Somit wird die Auswirkung des Rauschens innerhalb der phase-locked loop **PLL** auf das Phasenrauschen des spannungsgesteuerten Oszillators **VCO** minimiert. Das Rauschen der induktiven Kontrollspannung am Steuereingang **V_con** kann mittels einer großen Kapazität abgeblockt werden.

Beispiel 5:

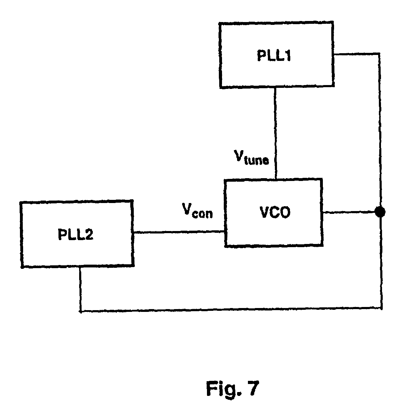

Eine modifizierte Variante ist in Figur 7 dargestellt. Dort ist der Oszillatorausgang mit den Eingängen zweier phase-locked loop **PLL1** und **PLL2** verbunden. Der Abstimmeingang $V_{tune}$ des spannungsgesteuerten Oszillators VCO ist mit dem Ausgang der phase-locked loop **PLL1** verbunden, während der Steuereingang **V_con** des spannungsgesteuerten Oszillators **VCO** an den Ausgang der phase-locked loop **PLL2** angeschlossen ist.

Die phase-locked loop **PLL2** dient dazu, technologische und Temperaturschwankungen zu kompensieren, während die phase-locked loop **PLL1** zur Feinabstimmung der Schwingfrequenz dient. Diese Methode eignet sich besonders für ein Modulationsverfahren, welches als Frequency Hopping bezeichnet wird. Dies ist ein spezielles Code Division Multiple Access Verfahren (CDMA), bei dem Sende- und Empfangsfrequenz nach einem vorgegebenen Code zeitlich geändert werden. Dies kann mittels phase-locked loop **PLL1** realisiert werden, während die sehr langsame phase-locked loop **PLL2** eine Grobeinstellung der Frequenz bewirkt.

Eine Anwendung dieser Erfindung ist der Standard "Bluetooth" zur drahtlosen Kommunikation über kurze Entfernungen. Dort wird das Frequency Hopping Verfahren angewendet. Die Anforderungen an das Phasenrauschen sind dort nicht allzu hoch, was eine integrierte CMOS-Lösung möglich macht.

In der vorliegenden Beschreibung wurde anhand konkreter Ausführungsbeispiele ein spannungsgesteuerter Oszillator mit LC-Schwingkreis erläutert. Es sei aber vermerkt, dass die vorliegende Erfindung nicht auf die Einzelheiten der Beschreibung in den Ausführungsbeispielen beschränkt ist, sondern durch die Ansprüche definiert wird.

**Patentansprüche**

1. Spannungsgesteuerter Oszillator **(VCO)** mit einer Oszillatorfrequenz schwingend, bestehend aus

   - einem LC-Schwingkreis mit mindestens einen ersten Induktivität **(L₁),**
   - einer steuerbaren Schaltvorrichtung **(S_v),** die im LC-Schwingkreis so angeordnet ist, dass sie mit der Oszillatorfrequenz periodisch einen leitenden und anschließend einen nichtleitenden Zustand aufweist und einen Steuereingang **(V_con)** besitzt, der an eine veränderbare Gleichspannung, die Steuerspannung $U_{con}$ angeschlossen ist und
   - einer weiteren Induktivität **(L₂),** welche parallel oder in Reihe zur der mindestens einen ersten Induktivität **(L₁)** über die mit der Oszillatorfrequenz betätigte Schaltvorrichtung **(S_v)** periodisch schaltbar ist.

2. Spannungsgesteuerter Oszillator **(VCO)** nach Anspruch 1, **dadurch gekennzeichnet, dass** mehreren ersten Induktivitäten *(L₁)* über je eine steuerbare Schaltvorrichtung **(S_v)** eine weitere Induktivität **(L₂)** parallel oder in Reihe mit der Oszillatorfrequenz periodisch schaltbar ist und die steuerbaren Schaltvorrichtungen **(S_v)** durch die veränderbare Steuerspannung $U_{con}$ steuerbar sind.

3. Spannungsgesteuerter Oszillator **(VCO)** nach Anspruch 1, **dadurch gekennzeichnet, dass** das Verhältnis der Dauer des leitenden Zustandes und der Dauer des nichtleitenden Zustandes der Schaltvorrichtungen **(S_v)** innerhalb einer Schwingungsperiode des Oszillators **(VCO)** in Abhängigkeit von der Steuerspannung $U_{con}$ veränderbar ist.

4. Spannungsgesteuerter Oszillator **(VCO)** nach einem oder mehreren der vorhergehenden Ansprüche, **dadurch gekennzeichnet, dass** entsprechend dem Verhältnis der Dauer des leitenden Zustandes und der Dauer des nichtleitenden Zustandes der Schaltvorrichtungen **(S_v)** innerhalb einer Schwingungsperiode des Oszillators **(VCO)** die zeitgemittelte, wirksame Induktivität in Abhängigkeit von der Steuerspannung $U_{con}$ veränderbar ist.

5. Spannungsgesteuerter Oszillator **(VCO)** nach einem oder mehreren der vorhergehenden Ansprüche, **dadurch gekennzeichnet, dass** die steuerbaren Schaltvorrichtungen **(S_v)** Schalttransistoren, insbesondere MOSFET, sind.

**6.** Spannungsgesteuerter Oszillator **(VCO)** nach einem oder mehreren der vorhergehenden Ansprüche, **dadurch gekennzeichnet, dass** die Gate-Anschlüsse **(G)** der MOSFET an den Steuereingang **(V$_{con}$)** der Steuerspannung U$_{con}$ geschaltet sind.

**7.** Spannungsgesteuerter Oszillator **(VCO)** nach einem oder mehreren der vorhergehenden Ansprüche, **dadurch gekennzeichnet, dass** die Source-Anschlüsse **(S)** der MOSFET an die Oszillatorfrequenz führende Teile der Schaltungsanordnung geschaltet sind.

**8.** Spannungsgesteuerter Oszillator **(VCO)** nach einem oder mehreren der vorhergehenden Ansprüche, **dadurch gekennzeichnet, dass** der Oszillator **(VCO)** in einer CMOS- oder bipolaren Technologie ausgeführt ist.

**9.** Spannungsgesteuerter Oszillator **(VCO)** nach einem oder mehreren der vorhergehenden Ansprüche, **dadurch gekennzeichnet, dass** der Oszillator **(VCO)** in Frequenzsynthesizern für Breitbandsysteme sowie fiir Multibandanwendungen und für die Takterzeugung und Taktrückgewinnung in Hochgeschwindigkeitsschaltungen, wie beispielsweise Mikroprozessoren und Speichern, Anwendung findet.

**10.** Spannungsgesteuerter Oszillator **(VCO)** nach einem oder mehreren der Ansprüche 4 bis 9 **dadurch gekennzeichnet, dass** zusätzlich zur spannungsgesteuerten Zeitgemittelten wirksamen Induktivität eine spannungsgesteuerte Kapazität **(M$_1$, M$_2$)** im Oszillator **(VCO)** integriert ist, welche über einen weiteren Steuereingang, den Abstimmeingang **(V$_{tune}$)** mit einer Abstimmspannung U$_{tune}$ verbunden ist.

**11.** Spannungsgesteuerter Oszillator **(VCO)** nach Anspruch 10, **dadurch gekennzeichnet, dass** die spannungsgesteuerte Kapazität mittels mindestens einer veränderbaren Kapazitätsdiode, insbesondere mittels zweier p-MOSFET **(M$_1$, M$_2$)** realisiert ist, wobei die wirksame Kapazität von der Abstimmspannung U$_{tune}$ an dem Abstimmeingang **(V$_{tune}$)** abhängt.

**12.** Spannungsgesteuerter Oszillator **(VCO)** nach einem oder mehreren der vorhergehenden Ansprüche, **dadurch gekennzeichnet, dass** der Abstimmeingang **(V$_{tune}$)** des Oszillators **(VCO)** mit einem Ausgang einer phase-locked loop **(PLL)** und der Ausgang des spannungsgesteuerten Oszillators **(VCO)** mit einem Eingang der phase-locked loop **(PLL)** verbunden ist.

**13.** Spannungsgesteuerter Oszillator **(VCO)** nach einem oder mehreren der vorhergehenden Ansprüche, **dadurch gekennzeichnet, dass** das Rauschen der Steuerspannüng U$_{con}$ am Steuereingang **(V$_{con}$)** mittels einer großen Kapazität zwischen dem Steuereingang **(V$_{con}$)** und der Masse abgeblockt wird.

**14.** Spannungsgesteuerter Oszillator **(VCO)** nach einem oder mehreren der vorhergehenden Ansprüche, **dadurch gekennzeichnet, dass** der Abstimmeingang **(V$_{tune}$)** des spannungsgesteuerten Oszillators **(VCO)** mit dem Ausgang der phase-locked loop **(PLL; PLL1)** verbunden ist und der Steuereingang **(V$_{con}$)** des spannungsgesteuerten Oszillators **(VCO)** an einen Ausgang einer weiteren phase-locked loop **(PLL2)** angeschlossen ist.

## Claims

**1.** Voltage-controlled oscillator **(VCO)** oscillating with an oscillator frequency, comprising

- an LC resonant circuit having at least one first inductance **(L$_1$)**,

- a controllable switching device **(S$_v$),** which is arranged in the LC resonant circuit in such a way that it has periodically with the oscillator frequency a conducting and subsequently a non-conducting state, and has a control input **(V$_{con}$)** connected to a variable DC voltage, the control voltage U$_{con}$, and

- a further inductance **(L$_2$),** which can periodically be connected in parallel or in series with the at least one first inductance **(L$_1$)** via the switching device **(S$_v$)** actuated with the oscillator frequency.

**2.** Voltage-controlled oscillator **(VCO)** according to Claim 1, **characterized in that** a further inductance **(L$_2$)** can be connected periodically with the oscillator frequency in parallel or in series with a plurality of first inductances **(L$_1$)** via a respective controllable switching device **(S$_v$)** and the controllable switching devices **(S$_v$)** can be controlled by the variable control voltage U$_{con}$.

**3.** Voltage-controlled oscillator **(VCO)** according to Claim 1, **characterized in that** the ratio of the duration of the conducting state and the duration of the non-conducting state of the switching devices **(S$_v$),** within an oscillation period of the oscillator **(VCO),** can be varied in a manner dependent on the control voltage U$_{con}$.

**4.** Voltage-controlled oscillator **(VCO)** according to one or more of the preceding claims, **characterized in that**, in accordance with the ratio of the duration of the conducting state and the duration of the non-conducting state of the switching devices **(S$_v$),** within an oscillation period of the oscillator **(VCO),** the time-averaged, effective inductance can be varied in a manner dependent on the control voltage U$_{con}$.

**5.** Voltage-controlled oscillator **(VCO)** according to one or more of the preceding claims, **characterized in that** the controllable switching devices **(S$_v$)** are switching transistors, in particular MOSFETs.

**6.** Voltage-controlled oscillator **(VCO)** according to one or more of the preceding claims, **characterized in that** the gate terminals **(G)** of the MOSFETs are connected to the control input **(V$_{con}$)** of the control voltage U$_{con}$.

**7.** Voltage-controlled oscillator **(VCO)** according to one or more of the preceding claims, **characterized in that** the source terminals **(S)** of the MOSFETs are connected to parts of the circuit arrangement which carry the oscillator frequency.

**8.** Voltage-controlled oscillator **(VCO)** according to one or more of the preceding claims, **characterized in that** the oscillator **(VCO)** is embodied in a CMOS or bipolar technology.

**9.** Voltage-controlled oscillator **(VCO)** according to one or more of the preceding claims, **characterized in that** the oscillator **(VCO)** is employed in frequency synthesizers for broadband systems and for multiband applications and for clock generation and clock recovery in high-speed circuits, such as, for example, microprocessors and memories.

**10.** Voltage-controlled oscillator **(VCO)** according to one or more of Claims 4 to 9, **characterized in that**, in addition to the voltage-controlled time-averaged effective inductance, a voltage-controlled capacitance **(M$_1$, M$_2$)** is integrated in the oscillator **(VCO)**, and is connected to a tuning voltage U$_{tune}$ via a further control input, the tuning input **(V$_{tune}$).**

**11.** Voltage-controlled oscillator **(VCO)** according to Claim 10, **characterized in that** the voltage-controlled capacitance is realized by means of at least one variable capacitance diode, in particular by means of two p-MOSFETs **(M$_1$, M$_2$),** the effective capacitance depending on the tuning voltage U$_{tune}$ at the tuning input **(V$_{tune}$).**

**12.** Voltage-controlled oscillator **(VCO)** according to one or more of the preceding claims, **characterized in that** the tuning input **(V$_{tune}$)** of the oscillator **(VCO)** is connected to an output of a phase-locked loop **(PLL)** and the output of the voltage-controlled oscillator **(VCO)** is connected to an input of the phase-locked loop **(PLL).**

**13.** Voltage-controlled oscillator **(VCO)** according to one or more of the preceding claims, **characterized in that** the noise of the control voltage U$_{con}$ at the control input **(V$_{con}$)** is blocked by means of a large capacitance between the control input **(V$_{con}$)** and earth.

**14.** Voltage-controlled oscillator **(VCO)** according to one or more of the preceding claims, **characterized in that** the tuning input **(V$_{tune}$)** of the voltage-controlled oscillator **(VCO)** is connected to the output of the phase-locked loop **(PLL; PLL1)** and the control input **(V$_{con}$)** of the voltage-controlled oscillator **(VCO)** is connected to an output of a further phase-locked loop **(PLL2).**

## Revendications

**1.** Oscillateur commandé en tension (VCO) avec une fréquence d'oscillateur oscillante, composé de

- un circuit oscillant LC comprenant au moins une première inductance (L$_1$),
- un dispositif de commutation commandable (S$_v$) qui est disposé dans le circuit oscillant LC de manière à présenter périodiquement à la fréquence de l'oscillateur un état conducteur et ensuite un état non conducteur et qui possède une entrée de commande (V$_{com}$) qui est raccordée à une tension continue variable, la tension de commande U$_{com}$, et
- une autre inductance (L$_2$) qui peut être branchée périodiquement en parallèle ou en série avec l'au moins une première inductance (L$_1$) par le biais du dispositif de commutation (S$_v$) actionné à la fréquence de l'oscillateur.

**2.** Oscillateur commandé en tension (VCO) selon la revendication 1, **caractérisé en ce qu'**une inductance supplémentaire (L$_2$) peut être branchée périodiquement en parallèle ou en série à la fréquence de l'oscillateur avec plusieurs premières inductances (L$_1$), à chaque fois par le biais d'un dispositif de commutation commandable (S$_v$) et les dispositifs de commutation commandables (S$_v$) peuvent être commandés par la tension de commande variable U$_{com}$.

**3.** Oscillateur commandé en tension (VCO) selon la revendication 1, **caractérisé en ce que** le rapport entre la durée de l'état conducteur et la durée de l'état non conducteur des dispositifs de commutation (S$_v$) au sein de la période d'oscillation de l'oscillateur (VCO) peut être modifié en fonction de la tension de commande $U_{com}$.

4. Oscillateur commandé en tension (VCO) selon une ou plusieurs des revendications précédentes, **caractérisé en ce que** l'inductance efficace moyennisée dans le temps peut être modifiée en fonction de la tension de commande $U_{com}$ d'après le rapport entre la durée de l'état conducteur et la durée de l'état non conducteur des dispositifs de commutation ($S_v$) au sein de la période d'oscillation de l'oscillateur (VCO).

5. Oscillateur commandé en tension (VCO) selon une ou plusieurs des revendications précédentes, **caractérisé en ce que** les dispositifs de commutation commandables ($S_v$) sont des transistors de commutation, plus précisément des MOSFET.

6. Oscillateur commandé en tension (VCO) selon une ou plusieurs des revendications précédentes, **caractérisé en ce que** les bornes de gâchette (G) des MOSFET sont branchées à l'entrée de commande ($V_{com}$) de la tension de commande $U_{com}$.

7. Oscillateur commandé en tension (VCO) selon une ou plusieurs des revendications précédentes, **caractérisé en ce que** les bornes de source (S) des MOSFET sont branchées aux éléments de l'arrangement de circuit qui déterminent la fréquence de l'oscillateur.

8. Oscillateur commandé en tension (VCO) selon une ou plusieurs des revendications précédentes, **caractérisé en ce que** l'oscillateur (VCO) est réalisé dans une technologie CMOS ou bipolaire.

9. Oscillateur commandé en tension (VCO) selon une ou plusieurs des revendications précédentes, **caractérisé en ce que** l'oscillateur (VCO) trouve son application dans les synthétiseurs de fréquence pour systèmes à large bande ainsi que pour les applications multibandes et pour la génération et le recouvrement d'horloge dans les circuits à grande vitesse comme les microprocesseurs et les mémoires, par exemple.

10. Oscillateur commandé en tension (VCO) selon une ou plusieurs des revendications 4 à 9, **caractérisé en ce qu'**un condensateur commandé en tension ($M_1$, $M_2$) est intégré dans l'oscillateur (VCO) en plus de l'inductance efficace moyennisée dans le temps commandée en tension, lequel est relié à une tension d'accord $U_{tune}$ par le biais d'une entrée de commande supplémentaire, l'entrée d'accord ($V_{tune}$).

11. Oscillateur commandé en tension (VCO) selon la revendication 10, **caractérisé en ce que** le condensateur commandé en tension peut être réalisé à l'aide d'au moins une diode varicap, plus précisément au moyen de deux MOSFET p ($M_1$, $M_2$), la capacité efficace dépendant ici de la tension d'accord $U_{tune}$ à l'entrée d'accord ($V_{tune}$).

12. Oscillateur commandé en tension (VCO) selon une ou plusieurs des revendications précédentes, **caractérisé en ce que** l'entrée d'accord ($V_{tune}$) de l'oscillateur (VCO) est reliée à une sortie d'une boucle à verrouillage de phase (PLL) et la sortie de l'oscillateur commandé en tension (VCO) est reliée à une entrée de la boucle à verrouillage de phase (PLL).

13. Oscillateur commandé en tension (VCO) selon une ou plusieurs des revendications précédentes, **caractérisé en ce que** les bruits de la tension de commande $U_{com}$ à l'entrée de commande ($V_{com}$) sont bloqués à l'aide d'un condensateur de grande capacité entre l'entrée de commande ($V_{com}$) et la masse.

14. Oscillateur commandé en tension (VCO) selon une ou plusieurs des revendications précédentes, **caractérisé en ce que** l'entrée d'accord ($V_{tune}$) de l'oscillateur commandé en tension (VCO) est reliée à la sortie de la boucle à verrouillage de phase (PLL ; PLL1) et l'entrée de commande ($V_{com}$) de l'oscillateur commandé en tension (VCO) est reliée à une sortie d'une boucle à verrouillage de phase supplémentaire (PLL2).

Fig. 1

Fig. 2

Fig. 3

Fig. 4

**Fig. 5**

**Fig. 6**

Fig. 7